# EUROPÄISCHE PATENTSCHRIFT

(11) **EP 2 328 264 B1**
(45) Veröffentlichungstag und Bekanntmachung des Hinweises auf die Patenterteilung: **18.04.2012**
(21) Anmeldenummer: 09171606.8
(22) Anmeldetag: 29.09.2009
(51) Int. Cl.: H02M 5/27, H02M 5/297

(54) **Direktumrichter sowie System mit einem solchen Direktumrichter**
Cycloconverter and system with such a cycloconverter
Convertisseur direct et système doté d'un tel convertisseur direct

(43) Veröffentlichungstag der Anmeldung: 01.06.2011
(73) Patentinhaber: ABB Schweiz AG, 5400 Baden (CH)
(72) Erfinder: Winkelnkemper, Manfred, CH-5408, Ennetbaden (CH); Korn, Arthur, CH-5400, Baden (CH)
(74) Vertreter: ABB Patent Attorneys

(56) Entgegenhaltungen:
- WO-A-2005/124985
- US-A1- 2004 022 081
- US-A1- 2008 315 819

## Beschreibung

### Technisches Gebiet

Die Erfindung bezieht sich auf das Gebiet der Leistungselektronik. Sie geht aus von einem Direktumrichter sowie von einem System mit einem solchen Direktumrichter gemäss den Oberbegriffen der unabhängigen Ansprüche.

### Stand der Technik

Direktumrichter, insbesondere Matrixumrichter, hatten in der Vergangenheit eher akademische Bedeutung. Heute jedoch gewinnen Direktumrichter vor allem für Industrielle Anwendungen an Bedeutung, da mittels eines Direktumrichters ohne aufwendigen Gleichspannungszwischenkreis oder Gleichstromzwischenkreis eine Eingangsspannung bzw. ein Eingangsstrom einer ersten Amplitude und einer ersten Frequenz direkt in eine Ausgangsspannung bzw. in einen Ausgangsstrom einer zweiten Amplitude und einer zweiten Frequenz umgewandelt werden kann. Ein solcher Direktumrichter ist beispielsweise in der US 6,900,998 B2 angegeben. Darin weist der Direktumrichter n=3 Eingangsphasenanschlüsse und p=3 Ausgangsphasenanschlüsse, d.h. der Direktumrichter der US 6,900,998 B2 ist eingangseitig und ausgangsseitig dreiphasig ausgebildet. Der Direktumrichter der US 6,900,998 B2 umfasst weiterhin neun zweipoligen Schaltzellen zum Schalten einer positiven und einer negativen Spannung zwischen den Polen, wobei jeder Ausgangsphasenanschluss mit jedem Eingangsphasenanschluss jeweils unmittelbar über eine Schaltzelle seriell verbunden ist.

Problematisch bei einem Direktumrichter nach der US 6,900,998 B2 ist, dass die Spannung an jedem Zweig, d.h. an jeder zweipoligen Schaltzelle nicht derart eingestellt werden kann, dass ein kontinuierlicher Stromfluss von einem Eingangsphasenanschluss zu einem Ausgangsphasenanschluss erzielt werden kann, wodurch keine aktive Stromeinstellung durch den jeweiligen Zweig möglich ist. Weiterhin ist mit dem Direktumrichter der US 6,900,998 B2 kein oder nur ein sehr eingeschränkter Austausch elektrischer Energie zwischen einzelnen Zweigen möglich. Soll der Direktumrichter aber in der Lage sein, eine grosse elektrische Energiemengen zu übertragen, so sind die Kapazitäten der Schaltzellen der US 6,900,998 B2 entsprechend gross zu Dimensionieren, woraus ein enormer Platzbedarf eines solchen Direktumrichters und erhebliche Kosten resultieren. Systeme, aufgebaut mit derartigen Direktumrichtern werden dadurch ebenfalls einen entsprechend grossen Platzbedarf aufweisen und entsprechend teuer sein.

### Darstellung der Erfindung

Aufgabe der Erfindung ist es deshalb, einen Direktumrichter anzugeben, mittels welchem eine beliebige und kontinuierliche Stromflusseinstellung von einem Eingangsphasenanschluss zu einem Ausgangsphasenanschluss des Direktumrichters und zudem ein Austausch elektrischer zwischen zweipoligen Schaltzellen des Direktumrichters möglich ist. Ferner ist es eine Aufgabe der Erfindung, ein System mit einem solchen erfindungsgemässen Direktumrichter anzugeben.

Diese Aufgaben werden durch die Merkmale des Anspruchs 1 bzw. des Anspruchs 6 gelöst. In den abhängigen Ansprüchen sind vorteilhafte Weiterbildungen der Erfindung angegeben.

Der erfindungsgemässe Direktumrichter umfasst n Eingangsphasenanschlüssen und p Ausgangsphasenanschlüssen, wobei n ≥ 2 und p ≥ 2 ist. Weiterhin umfasst der Direktumrichter n·p zweipoligen Schaltzellen zum Schalten mindestens einer positiven und mindestens einer negativen Spannung zwischen den Polen, wobei jeder Ausgangsphasenanschluss mit jedem Eingangsphasenanschluss jeweils über eine Schaltzelle seriell verbunden ist. Nach der Erfindung ist nun in jede serielle Verbindung mindestens eine Induktivität eingeschaltet. Die Induktivität in jeder seriellen Verbindung, d.h. in jedem Zweig zwischen einem Eingangsphasenanschluss und einem Ausgangsphasenanschluss ermöglicht vorteilhaft eine Spannungseinstellung durch die Schaltzellen derart, dass ein kontinuierlicher Stromfluss von einem Eingangsphasenanschluss zu einem Ausgangsphasenanschluss erzielt werden kann, wodurch eine aktive Stromeinstellung durch den jeweiligen Zweig möglich ist. Weiterhin ist mit dem erfindungsgemässen Direktumrichter ein nahezu beliebiger Austausch elektrischer Energie zwischen einzelnen Zweigen möglich.

Bei dem System nach der Erfindung mit einem vorstehend genannten erfindungsgemässen Direktumrichter ist der Direktumrichter an den Eingangsphasenanschlüssen über einen Transformator an ein elektrisches Wechselspannungsnetz angeschlossen. Alternativ dazu ist der erfindungsgemässe Direktumrichter an mindestens einem Eingangsphasenanschluss des Direktumrichters über eine Eingangfehlerstrombegrenzungsdrossel an das elektrische Wechselspannungsnetz angeschlossen. Insgesamt ist das erfindungsgemässe System somit denkbar einfach aufgebaut.

Diese und weitere Aufgaben, Vorteile und Merkmale der vorliegenden Erfindung werden aus der nachfolgenden detaillierten Beschreibung bevorzugter Ausführungsformen der Erfindung in Verbindung mit der Zeichnung offensichtlich.

### Kurze Beschreibung der Zeichnungen

Es zeigen:
- Fig. 1: eine erste Ausführungsform erste Ausführungsform eines Direktumrichters,
- Fig. 2: eine zweite Ausführungsform erste Ausführungsform eines Direktumrichters,
- Fig. 3: eine dritte Ausführungsform erste Ausführungsform eines Direktumrichters,
- Fig. 4: eine erste Ausführungsform eines Systems,
- Fig. 5: eine zweite Ausführungsform eines Systems,
- Fig.6: eine dritte Ausführungsform eines Systems,
- Fig. 7: eine vierte Ausführungsform eines Systems,
- Fig. 8: eine fünfte Ausführungsform eines Systems,
- Fig. 9: eine sechste Ausführungsform eines Systems,
- Fig. 10: eine siebte Ausführungsform eines Systems,
- Fig. 11: eine achte Ausführungsform eines Systems,
- Fig. 12: eine neunte Ausführungsform eines Systems,
- Fig. 13: eine zehnte Ausführungsform eines Systems,
- Fig. 14: eine elfte Ausführungsform eines Systems,
- Fig. 15: eine zwölfte Ausführungsform eines Systems und
- Fig. 16: eine dreizehnte Ausführungsform eines Systems,

Die in der Zeichnung verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen. Die beschriebenen Ausführungsformen stehen beispielhaft für den Erfindungsgegenstand und haben keine beschränkende Wirkung.

### Wege zur Ausführung der Erfindung

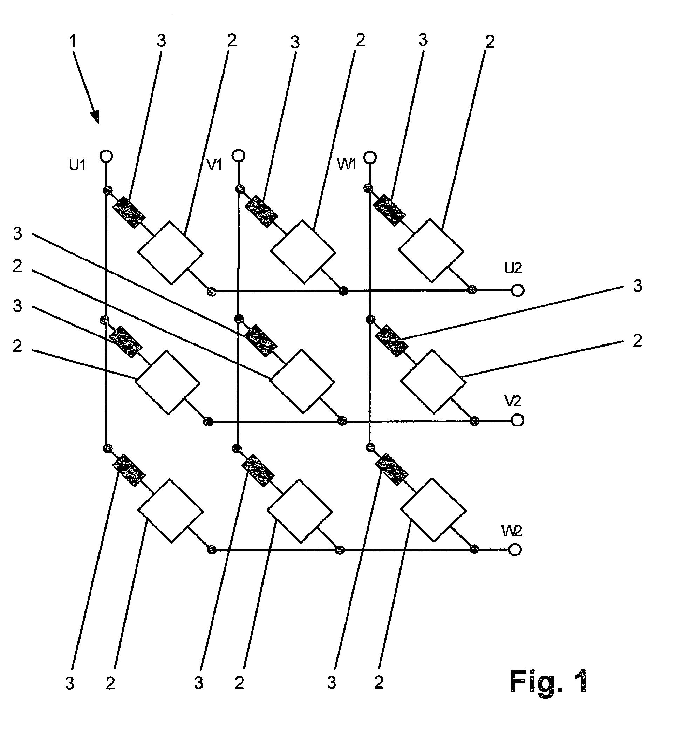

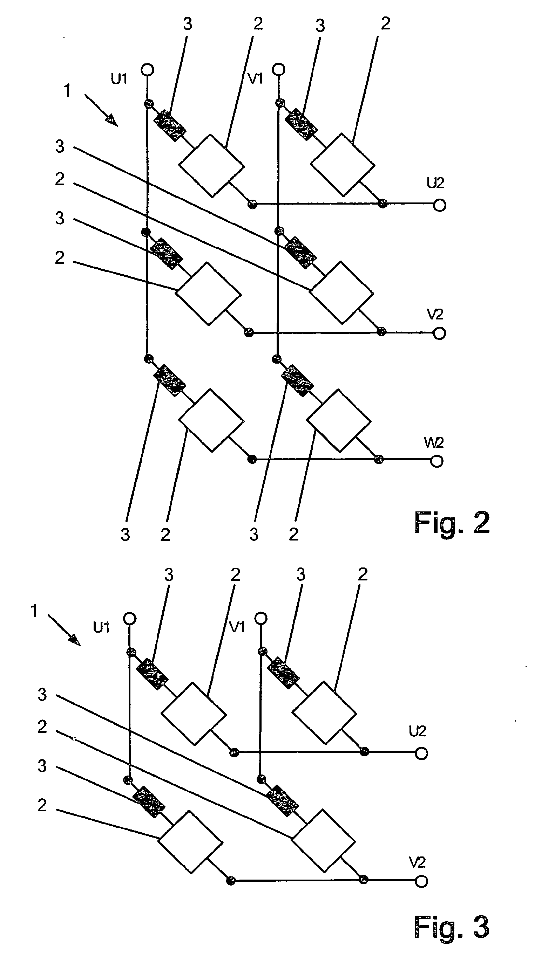

Der erfindungsgemässe Direktumrichter 1 umfasst allgemein n Eingangsphasenanschlüssen U1, V1, W1 und p Ausgangsphasenanschlüssen U2, V2, W2, wobei n ≥ 2 und p ≥ 2 ist. Weiterhin umfasst der Direktumrichter 1 n·p zweipoligen Schaltzellen 2 zum Schalten mindestens einer positiven und mindestens einer negativen Spannung zwischen den Polen, wobei jeder Ausgangsphasenanschluss U2, V2, W2 mit jedem Eingangsphasenanschluss U1, V1, W1 jeweils über eine Schaltzelle 2 seriell verbunden ist. In Fig. 1 ist diese serielle Verbindung für einen Direktumrichter mit n=3 Eingangsphasenanschlüssen U1, V1, W1 und p=3 Ausgangsphasenanschlüssen U2, V2, W2 beispielhaft gezeigt. Ferner zeigt Fig. 2 einen Direktumrichter mit n=2 Eingangsphasenanschlüssen U1, V1 und p=3 Ausgangsphasenanschlüssen U2, V2, W2, und Fig. 3 zeigt einen Direktumrichter mit n=2 Eingangsphasenanschlüssen U1, V1 und p=2 Ausgangsphasenanschlüssen U2, V2.

Nach der Erfindung ist nun in jede serielle Verbindung, d.h., wie vorstehend erwähnt, in die jeweilige Verbindung zwischen einem Ausgangsphasenanschluss U2, V2, W2 und einem Eingangsphasenanschluss U1, V1, W1 über die zugehörigen zweipolige Schaltzelle 2, mindestens eine Induktivität 3 eingeschaltet. Die Induktivität 3 in jeder seriellen Verbindung, d.h. in jedem Zweig zwischen einem Eingangsphasenanschluss U1, V1, W1 und einem Ausgangsphasenanschluss U2, V2, W2 ermöglicht vorteilhaft eine Spannungseinstellung durch die Schaltzellen 2 derart, dass ein kontinuierlicher Stromfluss von einem Eingangsphasenanschluss U1, V1, W1 zu einem Ausgangsphasenanschluss U2, V2, W2 erreicht werden kann, wodurch eine aktive Stromeinstellung durch den jeweiligen Zweig möglich ist. Darüber hinaus ist mit dem erfindungsgemässen Direktumrichter 1 ein nahezu beliebiger Austausch elektrischer Energie zwischen einzelnen Zweigen möglich.

Vorzugsweise weist jede Schaltzelle 2 vier nach Art einer Brückenschaltung verbundene ansteuerbare bidirektionale Leistungshalbleiterschalter mit gesteuerter unidirektionaler Stromführungsrichtung und einen zu der Brückenschaltung der Leistungshalbleiterschalter parallel geschalteten kapazitiven Energiespeicher auf. Denkbar sind aber auch zweipolige Schaltzellen 2, die allgemein als Multilevelschaltungen ausgebildet sind mindestens eine positiven und mindestens einer negative Spannung zwischen den Polen zu schalten in der Lage sind.

Der ansteuerbare bidirektionale Leistungshalbleiterschalter mit gesteuerter unidirektionaler Stromführungsrichtung ist insbesondere als Abschaltthyristor (GTO - Gate Turn-Off Thyristor) oder als integrierter Thyristor mit kommutierter Ansteuerelektrode (IGCT - Integrated Gate Commutated Thyristor) mit jeweils einer antiparallel geschalteten Diode ausgebildet. Es ist aber auch denkbar, einen ansteuerbaren Leistungshalbleiterschalter beispielsweise als Leistungs-MOSFET mit zusätzlich antiparallel geschalteter Diode oder als Bipolartransistor mit isoliert angeordneter Gateelektrode (IGBT) mit zusätzlich antiparallel geschalteter Diode auszubilden. Mittels des bereits vorstehend erwähnten nahezu beliebigen Austauschs elektrischer Energie zwischen einzelnen Zweigen und damit zwischen einzelnen Schaltzellen 2 können bei einem Direktumrichter 1, der grosse elektrische Energiemengen zu übertragen in der Lage sein soll, die kapazitiven Energiespeicher der Schaltzellen vorteilhaft entsprechend klein dimensioniert werden, woraus eine signifikante Platzeinsparung und eine deutliche Reduzierung der Kosten gegenüber bekannten Direktumrichtern folgt. Systeme, aufgebaut mit derartigen Direktumrichtern können dadurch ebenfalls einen entsprechend geringen Platzbedarf aufweisen und entsprechend kostengünstig sein.

In einer der Übersichtlichkeit nicht dargestellten Ausführungsform des erfindungsgemässen Direktumrichters ist in jede serielle Verbindung mindestens eine weitere zweipolige Schaltzelle 2 zum Schalten mindestens einer positiven und mindestens einer negativen Spannung zwischen den Polen eingeschaltet, wodurch die zu schaltende Spannung, d.h. die Spannungstragfähigkeit, über der gesamten seriellen Verbindung zwischen einem Eingangsphasenanschluss U1, V1, W1 und einem Ausgangsphasenanschluss U2, V2, W2 vorteilhaft erhöht werden kann.

Denkbar ist es auch, dass zu jeder Schaltzelle 2 mindestens eine weitere zweipolige Schaltzelle 2, beispielsweise wie vorstehend beschrieben ausgebildet, zum Schalten mindestens einer positiven und mindestens einer negativen Spannung zwischen den Polen parallel geschaltet ist. Dadurch lässt sich mit Vorteil ein höherer Strom, d.h. eine erhöhte Stromtragfähigkeit, durch die gesamte serielle Verbindung zwischen einem Eingangsphasenanschluss U1, V1, W1 und einem Ausgangsphasenanschluss U2, V2, W2 erreichen. Möglich ist es auch, dass zu jeder Serienschaltung der Schaltzelle 2 mit mindestens einer Induktivität 3 mindestens eine weitere Serienschaltung einer zweipoligen Schaltzelle 2 zum Schalten mindestens einer positiven und mindestens einer negativen Spannung zwischen den Polen mit mindestens einer weiteren Induktivität 3 parallel geschaltet ist.

Zum Schutz im Fehlerfall einer Schaltzelle 2 kann vorzugsweise parallel zu jeder Schaltzelle 2 ein Kurzschlusselement geschaltet sein.

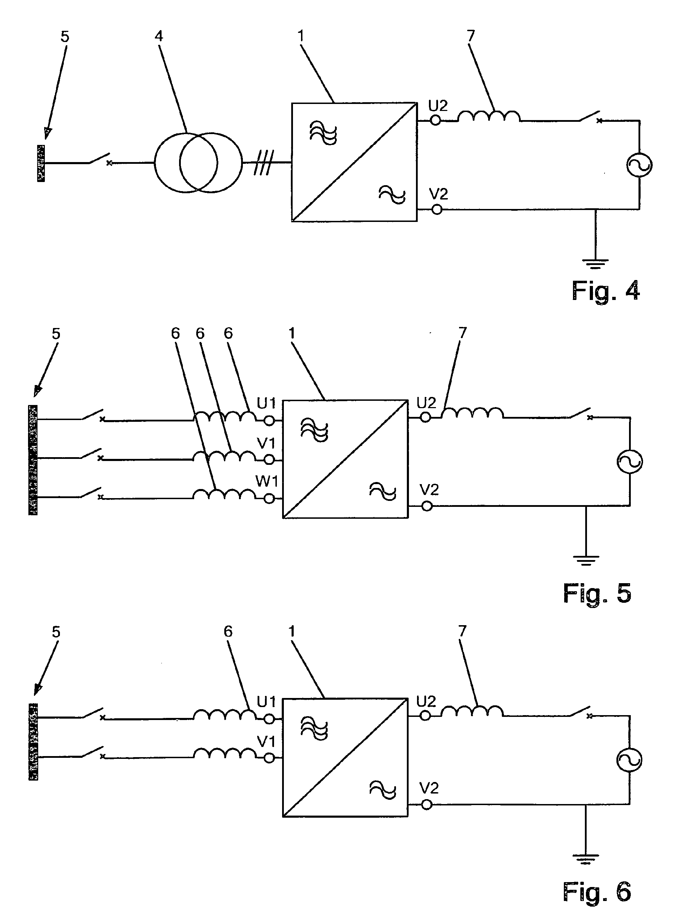

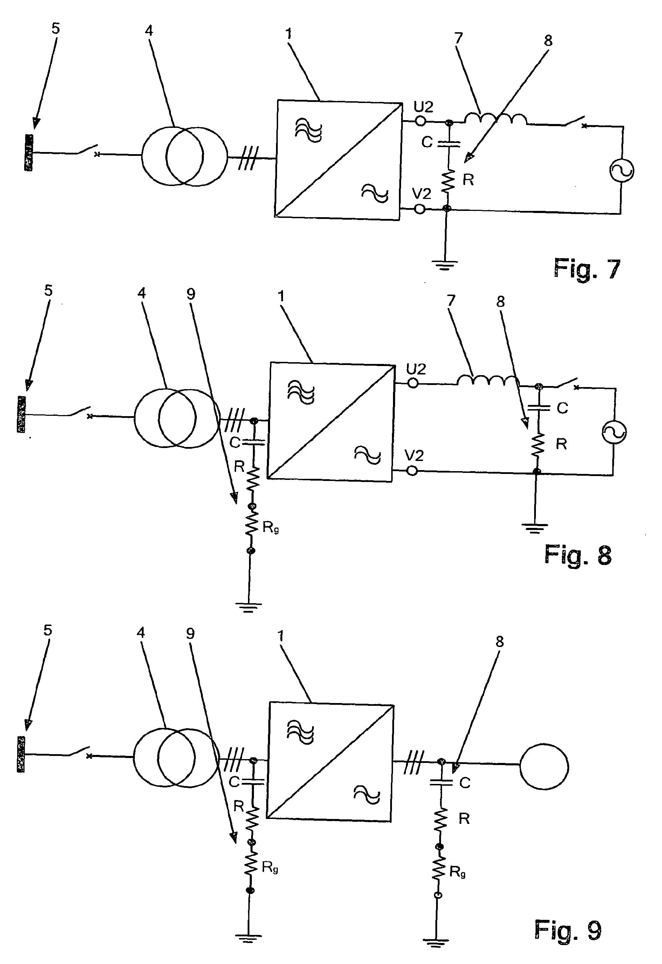

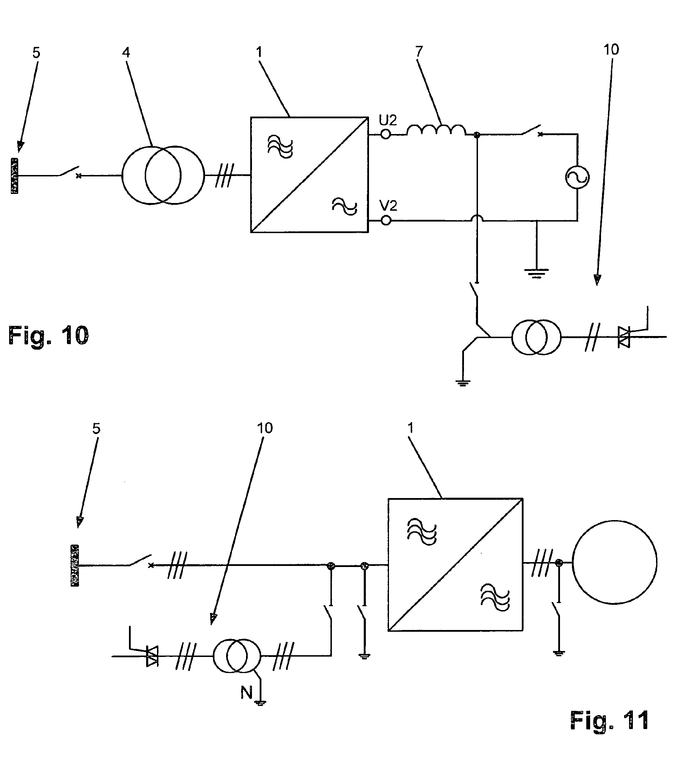

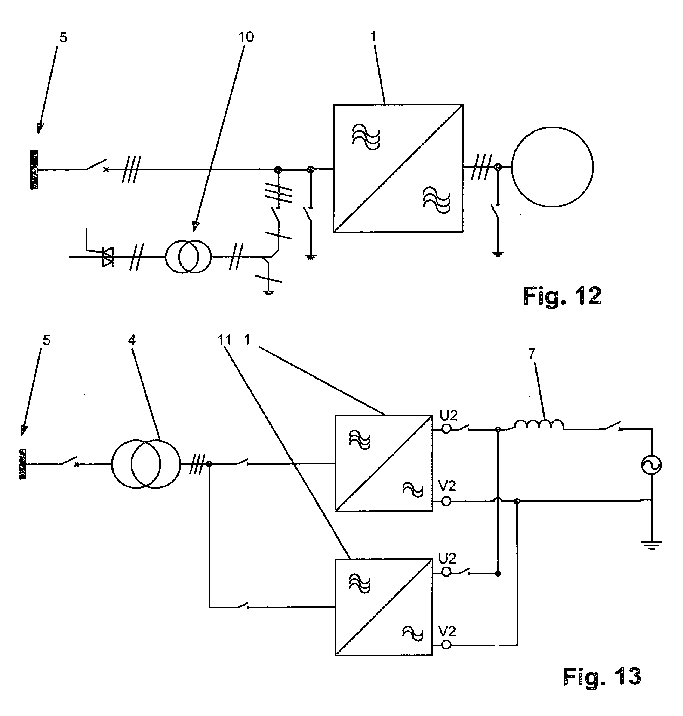

Ausführungsformen des erfindungsgemässen Systems sind in Fig. 4 bis Fig. 16 dargestellt und werden nachfolgend detailliert beschrieben, wobei Fig. 4 bis Fig. 8, Fig. 10, Fig. 13 und Fig. 14 beispielhaft ein System zur Kopplung eines dreiphasigen elektrischen Wechselspannungsnetzes 5 mit einem zweiphasigen elektrischen Wechselspannungsnetz, beispielsweise für eine Bahnnetzkopplung, angibt, und wobei Fig. 9, Fig. 11, Fig. 12, Fig. 15 und Fig. 16 beispielhaft ein System zur Kopplung eines dreiphasigen elektrischen Wechselspannungsnetzes 5 mit einer elektrischen Last, beispielsweise einer rotierenden elektrischen Maschine, angibt. Bei dem System nach der Erfindung mit einem vorstehend beschriebenen erfindungsgemässen Direktumrichter 1 ist der Direktumrichter 1 an den Eingangsphasenanschlüssen U1, V1, W1 über einen Transformator 4 an ein elektrisches Wechselspannungsnetz 5 angeschlossen, wie beispielhaft in Fig. 4, Fig. 7 bis Fig. 10 und Fig. 13 und Fig. 14 gezeigt. Alternativ dazu ist der erfindungsgemässe Direktumrichter 1 an mindestens einem Eingangsphasenanschluss U1, V1, W1 des Direktumrichters 1 über eine Eingangfehlerstrombegrenzungsdrossel 6 an das elektrisches Wechselspannungsnetz angeschlossen, wie beispielhaft in Fig. 6, aber auch in Fig. 5 und Fig. 14 bis Fig. 16 gezeigt. Ist ein Eingangsphasenanschluss U1, V1, W1 geerdet, kann vorzugsweise auf 1 eine Eingangfehlerstrombegrenzungsdrossel 6 an diesem Eingangsphasenanschluss U1, V1, W1 verzichtet werden. Die jeweilige Eingangfehlerstrombegrenzungsdrossel 6 begrenzt einen im Fehlerfall möglichen grossen eingangsseitigen Strom und schützt damit den Direktumrichter 1 vor Beschädigung oder Zerstörung. Gemäss Fig. 11 und Fig. 12 ist es beispielsweise für Anwendungen zum Betrieb einer rotierenden elektrischen Maschine auch denkbar, dass die Eingangsphasenanschlüsse U1, V1, W1 direkt mit einem elektrischen Wechselspannungsnetz 5 verbunden sind. Der Aufbau des erfindungsgemässen Systems ist damit insgesamt sehr einfach zu realisieren.

Weiterhin ist bei dem System optional an mindestens einem Ausgangsphasenanschluss U2, V2, W2 des Direktumrichters 1 eine Ausgangfehlerstrombegrenzungsdrossel 7 angeschlossen, wie beispielhaft in Fig. 4 bis Fig. 8, Fig. 10, Fig. 13 und Fig. 14 gezeigt. Ist ein Ausgangsphasenanschluss U2, V2, W2 geerdet, kann vorzugsweise auf 1 eine Ausgangfehlerstrombegrenzungsdrossel 7 an diesem Ausgangsphasenanschluss U2, V2, W2 verzichtet werden. Die jeweilige Ausgangfehlerstrombegrenzungsdrossel 7 begrenzt einen im Fehlerfall möglichen grossen ausgangsseitigen Strom und schützt damit den Direktumrichter 1 vor Beschädigung oder Zerstörung.

Gemäss Fig. 7 ist es möglich, dass ein RC-Filter 8 gebildet durch eine Serienschaltung eines Widerstandes R und einer Kapazität C mit der Ausgangfehlerstrombegrenzungsdrossel 7 verbunden und geerdet ist, um eine Begrenzung des auf die Isolationen (Transformator, Kabel) einwirkenden Spannungsgradient du/dt zu erreichen.

Gemäss Fig. 8 und Fig. 9 kann auch jeder Eingangsphasenanschluss U1, V1, W1 mit jeweils einem Flankenfilter 9 gebildet durch einen Serienschaltung eines Widerstandes R und einer Kapazität C verbunden sein, die Flankenfilter 9 dann miteinander verbunden sind und der Verbindungspunkt über einen Erdungswiderstand R_{g} geerdet ist. Auch ein solches Flankenfilter dient der der Begrenzung des auf die Isolationen (Transformator, Kabel) einwirkenden Spannungsgradienten du/dt. Optional ist der Verbindungspunkt der Flankenfilter 9 mit der Erdung des RC-Filters 8 verbunden, um eine Kopplung der beiden Filter 8, 9 zu erreichen.

Darüber hinaus ist allgemein bei dem erfindungsgemässen System an mindestens einen Eingangsphasenanschluss U1, V1, W1 eine Ladeeinrichtung 10 angeschlossen, wie in Fig. 11 und Fig. 12 dargestellt. Falls, wie vorstehend ausgeführt, an mindestens einem Eingangsphasenanschluss U1, V1, W1 des Direktumrichters 1 eine Eingangsfehlerstrombegrenzungsdrossel 6 angeschlossen ist, ist es auch denkbar, dass dann an dieser Eingangsfehlerstrombegrenzungsdrossel 6 eine Ladeeinrichtung 10 angeschlossen ist. Ferner kann eine solche Ladeeinrichtung 10 auch an die Ausgangfehlerstrombegrenzungsdrossel 7 angeschlossen sein, wie in Fig. 10 gezeigt. Im Falle, dass an mindestens einem Ausgangsphasenanschluss U2, V2, W2 des Direktumrichters 1 eine Ausgangfehlerstrombegrenzungsdrossel 7 angeschlossen ist, ist es auch denkbar, dass dann an dieser Ausgangfehlerstrombegrenzungsdrossel 7 eine Ladeeinrichtung 10 angeschlossen ist. Allgemein dient die Ladeeinrichtung 10 vorteilhaft der Ladung der kapazitiven Energiespeicher der Schaltzellen 2. Die Ladeeinrichtung 10 besteht aus einem Mittelspannungstrenner, einem einphasigen möglicherweise verstellbaren Ladetransformator, der aus einer geeigneten Hilfsspannung die benötigte Ladespannung erzeugt und einer Ladestrombegrenzungsmassname (ein Wechselstromsteller oder Ladewiderstand) auf einer beliebigen Seite des Ladetransformators. Es ist denkbar, dass sich mehrere Direktumrichter 1 eine Ladeeinrichtung 10 teilen. Jeder Direktumrichter 1 wird über einen eigenen Trenner mit der Ladevorrichtung verbunden, ein zu ladender Direktumrichter 1 wird dann durch Schliessen des jeweiligen Trenners mit der Ladeeinrichtung 10 verbunden.

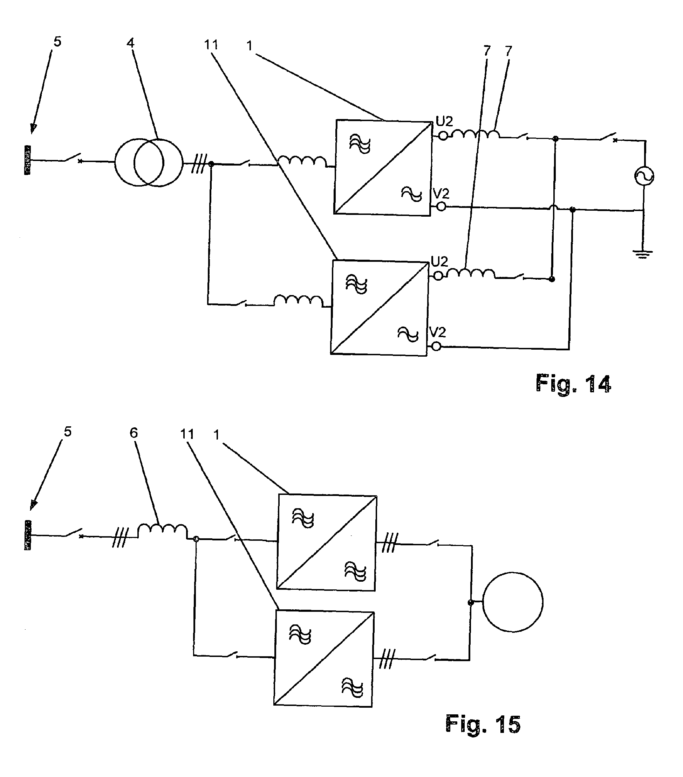

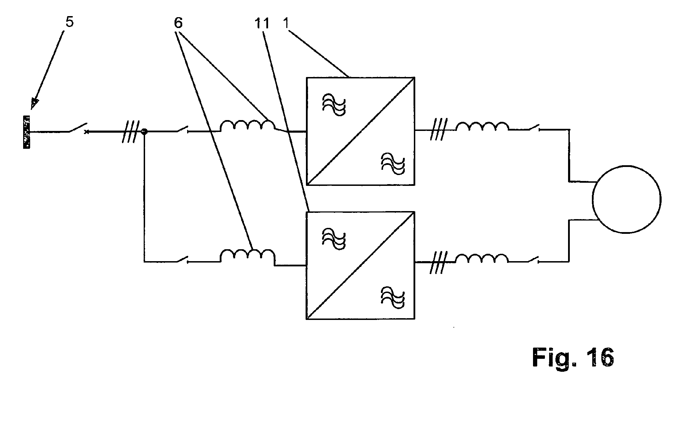

Bei dem System nach der Erfindung kann auch mindestens ein weiterer Direktumrichter 11 vorgesehen sein, wobei dieser weitere Direktumrichter 11 wie ein bereits vorstehend beschriebener efindungsgemässer Direktumrichter 1 ausgebildet ist und die Anzahl n an Eingangsphasenanschlüssen U1, V1, W1 des jeweiligen weiteren Direktumrichters 11 der Anzahl n an Eingangsphasenanschlüssen U1, V1, W1 des Direktumrichters 1 und die Anzahl p an Ausgangsphasenanschlüssen U2, V2, W2 des jeweiligen weiteren Direktumrichters 11 der Anzahl p an Ausgangsphasenanschlüssen U2, V2, W2 des Direktumrichters 1 entspricht. Vorzugsweise ist der jeweilige weitere Direktumrichter 11 an den Eingangsphasenanschlüssen U1, V1, W1 und Ausgangsphasenanschlüssen U2, V2, W2 des jeweiligen weiteren Direktumrichters 11 parallel mit dem Direktumrichter 1 an den Eingangsphasenanschlüssen U1, V1, W1 und Ausgangsphasenanschlüssen U2, V2, W2 des Direktumrichters 1 verbunden, wie beispielhaft in Fig. 13 und Fig. 15 gezeigt. Je nach Anwendung kann es auch sinnvoll sein, dass der jeweilige weitere Direktumrichter 11 gemäss Fig. 14 parallel mit dem Direktumrichter 1 verbunden ist. Auch eine ausgangsseitige Verbindung des weiteren Direktumrichters 11 mit dem Direktumrichter 1 über eine elektrische Last, beispielsweise über Wicklungen einer rotierenden elektrischen Maschine, wie in Fig. 16 beispielhaft gezeigt, sind denkbar.

### Bezugszeichenliste

- 1: Direktumrichter
- 2: Schaltzelle
- 3: Induktivität
- 4: Transformator
- 5: elektrisches Wechselspannungsnetz
- 6: Eingangsfehlerstrombegrenzungsdrossel
- 7: Ausgangsfehlerstrombegrenzungsdrossel
- 8: RC-Filter
- 9: Flankenfilter
- 10: Ladeeinrichtung
- 11: weitere Direktumrichter

## Patentansprüche

1. Direktumrichter (1) mit n Eingangsphasenanschlüssen (U1, V1, W1) und p Ausgangsphasenanschlüssen (U2, V2, W2), wobei n ≥ 2 und p ≥ 2 ist, mit (n·p) zweipoligen Schaltzellen (2) zum Schalten mindestens einer positiven und mindestens einer negativen Spannung zwischen den Polen umfasst, wobei jeder Ausgangsphasenanschluss (U2, V2, W2) mit jedem Eingangsphasenanschluss (U1, V1, W1) jeweils über eine Schaltzelle (2) seriell verbunden ist,
**dadurch gekennzeichnet,**
**dass** in jede serielle Verbindung mindestens eine Induktivität (3) eingeschaltet ist.

2. Direktumrichter (1) nach Anspruch 1, **dadurch gekennzeichnet, dass** jede Schaltzelle (2) vier nach Art einer Brückenschaltung verbundene ansteuerbare bidirektionale Leistungshalbleiterschalter mit gesteuerter unidirektionaler Stromführungsrichtung und einen zu der Brückenschaltung der Leistungshalbleiterschalter parallel geschalteten kapazitiven Energiespeicher aufweist.

3. Direktumrichter (1) nach Anspruch 1 oder 2, **dadurch gekennzeichnet, dass** in jede serielle Verbindung mindestens eine weitere zweipolige Schaltzelle (2) zum Schalten mindestens einer positiven und mindestens einer negativen Spannung zwischen den Polen eingeschaltet ist.

4. Direktumrichter (1) nach einem der Ansprüche 1 bis 3, **dadurch gekennzeichnet, dass** zu jeder Schaltzelle (2) mindestens eine weitere zweipolige Schaltzelle (2) zum Schalten mindestens einer positiven und mindestens einer negativen Spannung zwischen den Polen parallel geschaltet ist.

5. Direktumrichter (1) nach einem der Ansprüche 1 bis 3, **dadurch gekennzeichnet, dass** zu jeder Serienschaltung der Schaltzelle (2) mit mindestens einer Induktivität (3) mindestens eine weitere Serienschaltung einer zweipolige Schaltzelle (2) zum Schalten mindestens einer positiven und mindestens einer negativen Spannung zwischen den Polen mit mindestens einer weiteren Induktivität (3) parallel geschaltet ist.

6. Direktumrichter (1) nach einem der Ansprüche 1 bis 5, **dadurch gekennzeichnet, dass** parallel zu jeder Schaltzelle (2) ein Kurzschlusselement geschaltet ist.

7. System, **dadurch gekennzeichnet, dass** ein Direktumrichter (1) nach einem der Ansprüche 1 bis 6 an den Eingangsphasenanschlüssen (U1, V1, W1) über einen Transformator (4) an ein elektrisches Wechselspannungsnetz (5) angeschlossen ist.

8. System, **dadurch gekennzeichnet, dass** ein Direktumrichter nach einem der Ansprüche 1 bis 6 an mindestens einem Eingangsphasenanschluss (U1, V1, W1) des Direktumrichters (1) über eine Eingangfehlerstrombegrenzungsdrossel (6) an ein elektrisches Wechselspannungsnetz (5) angeschlossen ist.

9. System nach Anspruch 7 oder 8, **dadurch gekennzeichnet, dass** für an mindestens einem Ausgangsphasenanschluss (U2, V2, W2) des Direktumrichters (1) eine Ausgangfehlerstrombegrenzungsdrossel (7) angeschlossen ist.

10. System nach Anspruch 9, **dadurch gekennzeichnet, dass** ein RC-Filter (8) gebildet durch eine Serienschaltung eines Widerstandes (R) und einer Kapazität (C) mit der Ausgangfehlerstrombegrenzungsdrossel (7) verbunden und geerdet ist.

11. System nach einem der Ansprüche 7 bis 10, **dadurch gekennzeichnet, dass** jeder Eingangsphasenanschluss (U1, V1, W1) mit jeweils einem Flankenfilter (9) gebildet durch einen Serienschaltung eines Widerstandes (R) und einer Kapazität (C) verbunden ist, und
dass die Flankenfilter (9) miteinander verbunden sind und der Verbindungspunkt über einen Erdungswiderstand (R_{g}) geerdet ist.

12. System nach einem der Ansprüche 7 bis 11, **dadurch gekennzeichnet, dass** an mindestens einen Eingangsphasenanschluss (U1, V1, W1) eine Ladeeinrichtung (10) angeschlossen ist.

13. System nach Anspruch 9, **dadurch gekennzeichnet, dass** eine Ladeeinrichtung (10) an die Ausgangfehlerstrombegrenzungsdrossel (7) angeschlossen ist.

14. System nach einem der Ansprüche 7 bis 13, **dadurch gekennzeichnet, dass** mindestens ein weiterer Direktumrichter (11) nach einem der Ansprüche 1 bis 5 vorgesehen ist, wobei die Anzahl n an Eingangsphasenanschlüssen (U1, V1, W1) des jeweiligen weiteren Direktumrichters (11) der Anzahl n an Eingangsphasenanschlüssen (U1, V1, W1) des Direktumrichters (1) und die Anzahl p an Ausgangsphasenanschlüssen (U2, V2, W2) des jeweiligen weiteren Direktumrichters (11) der Anzahl p an Ausgangsphasenanschlüssen (U2, V2, W2) des Direktumrichters (1) entspricht, und
dass der jeweilige weitere Direktumrichter (11) an den Eingangsphasenanschlüssen (U1, V1, W1) und Ausgangsphasenanschlüssen (U2, V2, W2) des jeweiligen weiteren Direktumrichters (11) parallel mit dem Direktumrichter (1) an den Eingangsphasenanschlüssen (U1, V1, W1) und Ausgangsphasenanschlüssen (U2, V2, W2) des Direktumrichters (1) verbunden ist.

## Claims

1. Direct converter (1) comprising n input phase connections (U1, V1, W1) and p output phase connections (U2, V2, W2), where n ≥ 2 and p ≥ 2, comprising (n·p) two-pole switching cells (2) for switching at least one positive and at least one negative voltage between the poles, each output phase connection (U2, V2, W2) being connected in series with each input phase connection (U1, V1, W1) respectively via a switching cell (2),
**characterized**
**in that** at least one inductance (3) is connected into each series connection.

2. Direct converter (1) according to Claim 1, **characterized in that** each switching cell (2) has four drivable bidirectional power semiconductor switches having a controlled unidirectional current-carrying direction, said power semiconductor switches being connected in the manner of a bridge circuit, and a capacitive energy store connected in parallel with the bridge circuit of the power semiconductor switches.

3. Direct converter (1) according to Claim 1 or 2, **characterized in that** at least one further two-pole switching cell (2) for switching at least one positive and at least one negative voltage between the poles is connected into each series connection.

4. Direct converter (1) according to any of Claims 1 to 3, **characterized in that** at least one further two-pole switching cell (2) for switching at least one positive and at least one negative voltage between the poles is connected in parallel with each switching cell (2).

5. Direct converter (1) according to any of Claims 1 to 3, **characterized in that** there is connected in parallel with each series circuit formed by the switching cell (2) and at least one inductance (3) at least one further series circuit formed by a two-pole switching cell (2) for switching at least one positive and at least one negative voltage between the poles and at least one further inductance (3).

6. Direct converter (1) according to any of Claims 1 to 5, **characterized in that** a short-circuiting element is connected in parallel with each switching cell (2).

7. System, **characterized in that** a direct converter (1) according to any of Claims 1 to 6 is connected to an electrical AC voltage system (5) at the input phase connections (U1, V1, W1) via a transformer (4).

8. System, **characterized in that** a direct converter according to any of Claims 1 to 6 is connected to an electrical AC voltage system (5) at at least one input phase connection (U1, V1, W1) of the direct converter (1) via an input fault current limiting inductor (6).

9. System according to Claim 7 or 8, **characterized in that** an output fault current limiting inductor (7) is connected to at least one output phase connection (U2, V2, W2) of the direct converter (1).

10. System according to Claim 9, **characterized in that** an RC filter (8) formed by a series circuit comprising a resistor (R) and a capacitance (C) is connected to the output fault current limiting inductor (7) and grounded.

11. System according to any of Claims 7 to 10, **characterized in that** each input phase connection (U1, V1, W1) is connected to a respective edge filter (9) formed by a series circuit comprising a resistor (R) and a capacitance (C), and
**in that** the edge filters (9) are connected to one another and the junction point is grounded via a grounding resistor (Rg).

12. System according to any of Claims 7 to 11, **characterized in that** a charging device (10) is connected to at least one input phase connection (U1, V1, W1).

13. System according to Claim 9, **characterized in that** a charging device (10) is connected to the output fault current limiting inductor (7).

14. System according to any of Claims 7 to 13, **characterized in that** at least one further direct converter (11) according to any of Claims 1 to 5 is provided, the number n of input phase connections (U1, V1, W1) of the respective further direct converter (11) corresponding to the number n of input phase connections (U1, V1, W1) of the direct converter (1) and the number p of output phase connections (U2, V2, W2) of the respective further direct converter (11) corresponding to the number p of output phase connections (U2, V2, W2) of the direct converter (1), and
**in that** the respective further direct converter (11), at the input phase connections (U1, V1, W1) and output phase connections (U2, V2, W2) of the respective further direct converted (11), is connected in parallel with the direct converter (1) at the input phase connections (U1, V1, W1) and output phase connections (U2, V2, W2) of the direct converter (1).

## Revendications

1. Variateur direct (1) comprenant n bornes de phase d'entrée (U1, V1, W1) et p bornes de phase de sortie (U2, V2, W2), avec n ≥ 2 et p ≥ 2, comprenant (n.p) cellules de commutation (2) bipolaires pour commuter au moins une tension positive et au moins une tension négative entre les pôles, chaque borne de phase de sortie (U2, V2, W2) étant branchée en série avec chaque borne de phase d'entrée (U1, V1, W1) à chaque fois par le biais d'une cellule de commutation (2),
**caractérisé en ce**
**qu'**au moins une inductance (3) est connectée dans chaque liaison série.

2. Variateur direct (1) selon la revendication 1, **caractérisé en ce que** chaque cellule de commutation (2) présente quatre semiconducteurs de puissance bidirectionnels commandables connectés à la manière d'un circuit en pont avec sens de circulation du courant unidirectionnel commandé et un accumulateur d'énergie capacitif branché en parallèle avec le circuit en pont des semiconducteurs de puissance.

3. Variateur direct (1) selon la revendication 1 ou 2, **caractérisé en ce que** dans chaque liaison série est connectée au moins une cellule de commutation (2) bipolaire supplémentaire pour commuter au moins une tension positive et au moins une tension négative entre les pôles.

4. Variateur direct (1) selon l'une des revendications 1 à 3, **caractérisé en ce qu'**au moins une cellule de commutation (2) bipolaire supplémentaire pour commuter au moins une tension positive et au moins une tension négative entre les pôles est branchée en parallèle avec chaque cellule de commutation (2).

5. Variateur direct (1) selon l'une des revendications 1 à 3, **caractérisé en ce qu'**au moins un circuit série supplémentaire composé d'une cellule de commutation (2) bipolaire pour commuter au moins une tension positive et au moins une tension négative entre les pôles avec au moins une inductance supplémentaire (3) est branché en parallèle avec chaque circuit série de la cellule de commutation (2) avec au moins une inductance (3).

6. Variateur direct (1) selon l'une des revendications 1 à 5, **caractérisé en ce qu'**un élément de court-circuit est branché en parallèle avec chaque cellule de commutation (2).

7. Système, **caractérisé en ce qu'**un variateur direct (1) selon l'une des revendications 1 à 6 est branché à un réseau électrique à tension alternative (5) au niveau des bornes de phase d'entrée (U1, V1, W1) par le biais d'un transformateur (4).

8. Système, **caractérisé en ce qu'**un variateur direct selon l'une des revendications 1 à 6 est branché à un réseau électrique à tension alternative (5) au niveau d'au moins l'une des bornes de phase d'entrée (U1, V1, W1) du variateur direct (1) par le biais d'une bobine de limitation du courant de défaut en entrée (6).

9. Système selon la revendication 7 ou 8, **caractérisé en ce qu'**une bobine de limitation du courant de défaut en sortie (7) est raccordée à au moins une borne de phase de sortie (U2, V2, W2) du variateur direct (1).

10. Système selon la revendication 9, **caractérisé en ce qu'**un filtre RC (8) formé par un circuit série constitué d'une résistance (R) et d'un condensateur (C) est relié à la bobine de limitation du courant de défaut en sortie (7) et mis à la terre.

11. Système selon l'une des revendications 7 à 10, **caractérisé en ce que** chaque borne de phase d'entrée (U1, V1, W1) est à chaque fois reliée avec un filtre à flanc (9) formé par un circuit série constitué d'une résistance (R) et d'un condensateur (C) et **en ce que** les filtres à flanc (9) sont reliés entre eux et le point de liaison est relié à la terre par le biais d'une résistance de mise à la terre (Rg).

12. Système selon l'une des revendications 7 à 11, **caractérisé en ce qu'**un dispositif de charge (10) est raccordé à au moins une borne de phase d'entrée (U1, V1, W1).

13. Système selon la revendication 9, **caractérisé en ce qu'**un dispositif de charge (10) est raccordé à la bobine de limitation du courant de défaut en sortie (7).

14. Système selon l'une des revendications 7 à 13, **caractérisé en ce qu'**il est prévu au moins un variateur direct supplémentaire (11) selon l'une des revendications 1 à 5, le nombre n de bornes de phase d'entrée (U1, V1, W1) du variateur direct supplémentaire (11) respectif correspondant au nombre n de bornes de phase d'entrée (U1, V1, W1) du variateur direct (1) et le nombre p de bornes de phase de sortie (U2, V2, W2) du variateur direct supplémentaire (11) respectif correspondant au nombre p de bornes de phase de sortie (U2, V2, W2) du variateur direct (1), et **en ce que** le variateur direct supplémentaire (11) respectif est relié au niveau des bornes de phase d'entrée (U1, V1, W1) et des bornes de phase de sortie (U2, V2, W2) du variateur direct supplémentaire (11) respectif en parallèle avec le variateur direct (1) au niveau des bornes de phase d'entrée (U1, V1, W1) et des bornes de phase de sortie (U2, V2, W2) du variateur direct (1).
